# EUROPEAN PATENT SPECIFICATION

(11) **EP 1 481 399 B1**
(45) Date of publication and mention of the grant of the patent: **03.05.2006**
(21) Application number: 03702925.3
(22) Date of filing: 17.02.2003
(51) Int. Cl.: G11C 16/22, G11C 16/20

(54) **PRODUCT AND METHOD FOR PREVENTING INCORRECT STORAGE OF DATA**
PRODUKT UND VERFAHREN ZUR VERHINDERUNG DER FALSCHEN SPEICHERUNG VON DATEN
PRODUIT ET PROCEDE PERMETTANT D'EVITER LE STOCKAGE INCORRECT DE DONNEES

(30) Priority: 05.03.2002 WO PCT/SG02/00041
(43) Date of publication of application: 01.12.2004
(60) Divisional application: 05106384.0
(73) Proprietor: Koninklijke Philips Electronics N.V., 5621 BA Eindhoven (NL)
(72) Inventor: WIN, Naing, NL-5656 AA Eindhoven (NL); CAI, Jun, NL-5656 AA Eindhoven (NL); JIMSON, Joseph, NL-5656 AA Eindhoven (NL); LAM, Weng, K., NL-5656 AA Eindhoven (NL)
(74) Representative: Steenbeek, Leonardus Johannes
(86) International application number: PCT/IB2003/000658
(87) International publication number: WO 2003/075140

(56) References cited:
- US-A- 5 070 481
- US-A- 5 371 709
- US-A- 5 768 208
- PATENT ABSTRACTS OF JAPAN vol. 018, no. 181 (P-1718), 28 March 1994 (1994-03-28) -& JP 05 342115 A (HITACHI LTD), 24 December 1993 (1993-12-24)
- PATENT ABSTRACTS OF JAPAN vol. 1999, no. 05, 31 May 1999 (1999-05-31) -& JP 11 051721 A (FUJI ELECTRIC CO LTD), 26 February 1999 (1999-02-26)
- PATENT ABSTRACTS OF JAPAN vol. 1995, no. 05, 30 June 1995 (1995-06-30) & JP 07 044468 A (HITACHI LTD), 14 February 1995 (1995-02-14)

## Description

The invention relates to a product comprising a power supply, a processor having an input for receiving a power-down signal indicating a status of the power supply and having another input coupled to another supply, and a non-volatile memory for storing data supplied by the processor. The invention also relates to a method of preventing incorrect storage of data in a product, which product comprises a power supply, a processor having an input for receiving a power-down signal indicating a status of the power supply, and a non-volatile memory for storing data supplied by the processor.

An embodiment of such a product is known from US 5,896,338. The known product has a circuit which abruptly stops writing operations to a non-volatile memory when receiving the power-down signal by sending a signal to the non-volatile memory.

As will be known to persons skilled in the art, many important data are stored in current products in the non-volatile memory, hereinafter also called NVM, which is frequently accessed by the processor. This leads to an increased risk of NVM corruption when NVM writing would happen during a power-down phase. Therefore, ensuring integrity of NVM data during the power-down phase is a very critical issue in products. A standard software solution as used with processors of type SAA56XX keeps the software waiting in an infinite loop as soon as the power-down signal has a value corresponding to the power-down status. One would expect that no NVM read/write activity would happen thereafter. However, experiments showed that there is a risk that NVM writing does take place when a supply voltage of the other supply drops to a level of around 2.2V. In other words, the standard software solution cannot fully protect the NVM from becoming corrupted.

Alternatively, the product may have a circuit as in the known product. However, it is a drawback of the known product that data in the NVM become corrupted when an ongoing writing operation from the processor to the NVM is interrupted.

JP 05 342 115 A discloses a processor receiving power from a maintaining power supply which is capable of continuing supplying an output voltage during a predetermined length of time after the main power source is interrupted. The predetermined length of time is determined by the energy stored in a capacitor coupled to an input of the maintaining power supply. When an interruption of the main power supply is detected, an interruption signal is sent to the processor, which then finishes first an ongoing updating of data of the memory.

It is an object of the invention to provide a simple yet effective way to obviate NVM data corruption during the power-down phase.

The invention is defined by the independent claims. The dependent claims define advantageous embodiments.

In one aspect the object is realized in that the processor is adapted for detecting a power-down status of the power supply by repeatedly checking the power-down signal and, upon detection that the power-down signal has a value corresponding to the power-down status, completing an ongoing writing operation and stopping the storage of data. In this way, the processor is adapted to complete an ongoing writing operation after detection of the power-down status, thereby avoiding an abrupt interruption, which would result in data corruption. Thereafter, all writing to the NVM is stopped before the supply voltage of the other supply has dropped below a value at which the processor operates unreliably. This power-down mode stops the operation of the processor completely.

In addition, a discharge circuit for discharging the other supply is present, which is only conducting when the power-down signal has a value corresponding to the power-down status.

When stopping the operation of the processor completely, via a power-down mode, thereby ensuring that all random software activity, which might cause NVM corruption during the power-down phase is stopped, it is no longer drawing current from its supply. As a result, the supply voltage of the processor decreases only slowly. If the power is supplied again to the product while the supply voltage of the processor has not yet decreased below a predetermined level, the processor does not restart until a subsequent cycle of the power-down phase of a sufficiently long duration has been completed. The predetermined level may be a value as mentioned in datasheets of the processor or a value determined by experiments. The discharge circuit ensures that the other supply is readily discharged below the predetermined level, thereby ensuring that the processor restarts if power is supplied again to the product.

It is advantageous if the discharge circuit comprises an electronic switch, which is conducting during the power-down phase. This switch is adapted to conduct a current to discharge the supply.

It is a further advantage if the discharge circuit is adapted to carry a predetermined discharge current, when the power-down signal has the value corresponding to the power-down status. High surge currents are thereby avoided

In a further modification, the discharge current is substantially equal to a current drawn by the processor from the supply during operation. In this further modification, the supply voltage will drop during the power-down phase below the predetermined level at substantially the same rate as when the processor continues to operate.

The product may be any product in which a non-volatile memory is present, like a television, a video, an audio a computer or a communication product.

These and other aspects of the product and the method of the invention will be further elucidated and described with reference to the drawings, in which:
Fig. 1 shows a block diagram of the product
Fig. 2 shows timing diagrams of the known product
Figs. 3 and 4 show the time difference between the solution of using the power-down mode and not using the power-down mode.
Fig. 5 shows a simplified diagram of the circuit and currents that influence the discharge time; and
Fig. 6 shows an embodiment of the discharge circuit.

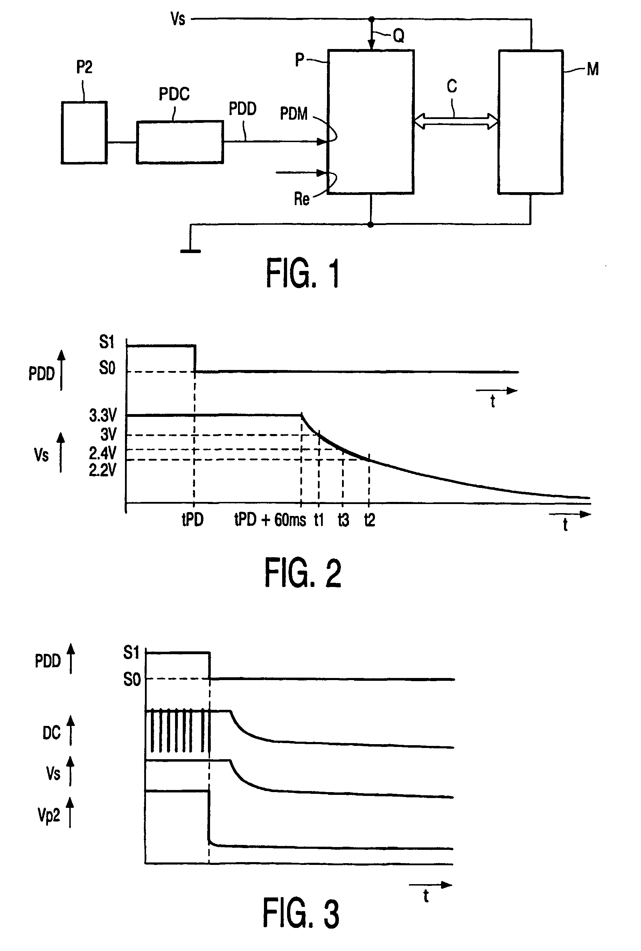

The product of Fig. 1 has a power supply P2, being the main power supply of the product. A processor P is connected via input Q to another supply having a supply voltage Vs. Also a NVM M for storing data supplied by the processor (P) is connected to the other supply. Via connections C, data, enable signals and clock signals are transferred between the processor P and the NVM M. A power-down detection circuit PDC is coupled to the power supply P2 to detect a status of the power supply P2 and transmit a power-down signal PDD to a power-down input PDM of the processor P. The processor has also a power-on reset input Re which keeps the processor P on hold during a start-up phase until the supply voltage Vs has reached a value ensuring proper functioning of the processor P.

A typical operating range of the NVM M is from 2.5V to 3.6V while for a processor P of the type SAA56XX the operating range is from 3.0 to 3.6V. However, experiments have shown that the processor P is still operating until 2.2V if a power-on reset signal is absent or delayed at the power-on reset input Re of the processor P during a power-down phase. The reset signal cannot be used to stop the operation of the processor P during a power-down phase, because it would stop the operation too late and abruptly without allowing a proper shut-down of the software activity.

As is shown in the graph of the supply voltage Vs versus time t in Fig. 2, if data are written from the processor P to the NVM M via the connections C between times t1 and t2, data inside the NVM M may be corrupted because the processor P does not operate reliably below 3.0V. Below 3.0 V, algorithms might not work correctly anymore in the processor P and, moreover, data could be corrupted, resulting in a risk of undesired writing of incorrect data to the NVM M. To address this risk, the power-down mode provided by the processor P totally stops the software activity before the supply voltage Vs enters the region where the processor P does not operate reliably anymore. The power-down mode is controlled by the power-down signal PDD. If the power supply P2 is operating, the power-down signal has a power-on value S1. If the power supply P2 stops, the power-down signal has a power-down value S0, indicating that the power supply P2 is in the power-down status. In order to enable correct stopping of the software activity, the other supply is adapted to supply the typical operating voltage, being 3.3V for the SAA56XX type of processors, during a period of about 60ms after time tPD, being the time when the power-down signal has a transition from the power-on value S1 to the power-down value S0.

The algorithm is incorporated in the processor and comprises the steps of:
- checking whether the power-down signal PDD has the power-down value S0.
- if so, a second check is done after a predetermined time delay, for example 10 ms. If not, the routine is restarted.
- if, also during the second check, the power-down value S0 is detected, then upon completion of an ongoing writing operation the power-down mode is started by the processor P which comprises putting the software in an infinite waiting loop and thereafter stopping the operation of the processor P. If the power-down value S0 is not detected, the routine is restarted.

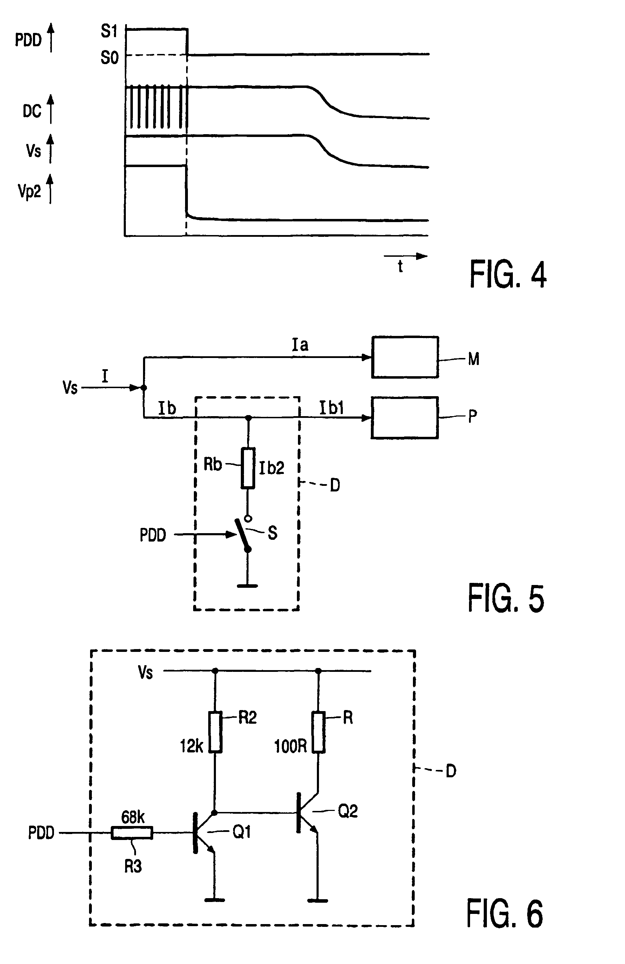

The side effect of the power-down mode is that it takes a longer time to discharge the other supply as the power-down mode consumes a very low power. Figs. 3 and 4 show the time difference between the solution of using the power-down mode and not using the power-down mode. As is known from the processor specification, the reset input Re is coupled to the other supply. If the power supply P2 restarts before a time t3 as shown in Fig. 2, which is before supply voltage Vs has dropped below a value of 2.4V for the processor types SAA56xx, the reset signal at the power-on reset input Re keeps the processor P in the power-down mode.

In Figs. 3 and 4, the following waveforms are shown as a function of time t from top to bottom: power-down signal PDD, data Dc transmitted via the connections C, the supply voltage Vs, and the voltage Vp2 of the power supply P2.

An extra discharge circuit D as shown in Fig. 5 ensures that voltage Vs drops rapidly below the predetermined level. The electronic switch S is controlled by the power-down signal PDD. If the power-down signal PDD has the value S0, corresponding to the power-down status, then the switch S is conducting. A discharge current Ib2 is determined by a resistor Rb having a value R by the formula: Ib2=Vs/R. The following relationships are valid for the currents shown in Fig.5:
I = Ia + Ib,
Ib =Ib1 + Ib2, and generally
Ib>10 x Ia.

When the power supply P2 is operating, Ib1 is equal to Ib and Ib2 is 0. When the power supply P2 stops, Ib1 drops to a very low value. When Ib2 is designed to be substantially equal to Ib1, Ib2 will start to flow and compensate for the drop of Ib1. As a result, Ib remains approximately constant, resulting in a drop of supply voltage Vs by substantially the same value as shown in Fig. 3.

In the discharge circuit D of Fig. 6, a transistor Q2 fulfills the function of the switch S. Transistor Q1 receives the power-down signal via resistor R3.

If the power-down signal has the power-down value S0 of substantially zero volt, the transistor Q1 is turned off. As a result, a current flowing through resistor R2 will turn on transistor Q2.

If the power-down signal has the power-on value S1, transistor Q1 is turned on and carries the current coming from resistor R2. Consequently, transistor Q2 does not receive any base current and will be turned off.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. Use of the verb "comprise" and its conjugations does not exclude the presence of elements or steps other than those stated in a claim. The article "a" or "an" preceding an element does not exclude the presence of a plurality of such elements. The invention can be implemented by means of hardware comprising several distinct elements, and by means of a suitably programmed computer. In the device claim enumerating several means, several of these means can be embodied by one and the same item of hardware. The mere fact that certain measures are recited in mutually different dependent claims does not indicate that a combination of these measures cannot be used to advantage.

## Claims

1. A product comprising:
a power supply (P2);
a processor (P) having an input for receiving a power-down signal (PDD) indicating a status of the power supply (P2) and having another input (Q) coupled to another supply;
a non volatile memory (M) for storing data supplied by the processor (P),
the processor (P) being adapted for:
detecting a power-down status of the power supply (P2) by repeatedly checking the power-down signal (PDD); and
upon detection that the power down signal (PDD) has a value (SO) corresponding to the power-down status, completing an ongoing writing operation, and stopping the storage of data, **characterized by** a discharge circuit (D) controlled by said power-down signal (PDD) for discharging the other supply, substantially only when the discharge circuit (D) unit is conducting, the discharge circuit (D) being only conducting when the power-down signal (PDD) has the value (SO) corresponding to the power-down status.

2. A product as claimed in claim 1, wherein the discharge circuit (D) comprises an electronic switch (S).

3. A product as claimed in claim 1, wherein the discharge circuit (D) is adapted to carry a predetermined discharge current, when the power-down signal has the value (SO) corresponding to the power-down status.

4. A method of preventing incorrect storage of data in a product, which product comprises:
a power supply (P2);
a processor (P) having an input for receiving a power-down-signal (PDD) indicating a status of the power supply (P2) and having another input (Q) coupled to another supply; and
a non-volatile memory (M) for storing data supplied by the processor (P), the method comprising the steps of:
detecting a power-down status of the power supply (P2) by repeatedly checking the power-down signal (PDD);
upon detection that the power-down signal (PDD) has a value (SO) corresponding to the power-down status, completing an ongoing writing operation, and stopping the storage of data; **characterized in that** the product further comprises a discharge circuit (D) controlled by the power-down signal (PDD) for discharging the other supply, substantially only when the discharge circuit (D) is conducting, which is only conducting when the power-down signal (PDD) has a value (SO) corresponding to the power-down status, and that the method further comprises the step of discharging the other supply with the discharge circuit (D) when the power-down signal (PDD) has a value (SO) corresponding to the power-down status.

## Patentansprüche

1. Produkt, umfassend:
eine Stromversorgung (P2);
einen Prozessor (P), der einen Eingang zum Empfangen eines Ausschaltsignals (PDD) aufweist, das einen Status der Stromversorgung (P2) anzeigt, und einen anderen Eingang (Q) aufweist, der mit einer anderen Versorgung gekoppelt ist;
und einen nichtflüchtigen Speicher (M) zum Speichern von Daten, die vom Prozessor (P) geliefert werden,
wobei der Prozessor (P) ausgeführt ist:
einen Ausschaltzustand der Stromversorgung (P2) durch wiederholtes Prüfen des Ausschaltsignals (PDD) zu detektieren und
auf die Detektion hin, dass das Ausschaltsignal (PDD) einen Wert (SO) aufweist, der dem Ausschaltzustand entspricht, einen laufenden Schreibvorgang abzuschließen und die Speicherung von Daten zu stoppen, **gekennzeichnet durch** eine Entladeschaltung (D), die **durch** das Ausschaltsignal (PDD) gesteuert ist, zum Entladen der anderen Versorgung im Wesentlichen nur dann, wenn die Entladeschaltungseinheit (D-Einheit) leitend ist, wobei die Entladeschaltung (D) nur leitend ist, wenn das Ausschaltsignal (PDD) den Wert (S0) aufweist, der dem Ausschaltzustand entspricht.

2. Produkt nach Anspruch 1, wobei die Entladeschaltung (D) einen elektronischen Schalter (S) umfasst.

3. Produkt nach Anspruch 1, wobei die Entladeschaltung (D) ausgeführt ist, einen vorgegebenen Entladestrom zu transportieren, wenn das Ausschaltsignal den Wert (SO) aufweist, der dem Ausschaltzustand entspricht.

4. Verfahren des Verhinderns falscher Speicherung von Daten in einem Produkt, wobei das Produkt umfasst:
eine Stromversorgung (P2);
einen Prozessor (P), der einen Eingang zum Empfangen eines Aussehaltsignals (PDD) aufweist, das einen Status der Stromversorgung (P2) anzeigt, und einen anderen Eingang (Q) aufweist, der mit einer anderen Versorgung gekoppelt ist; und
einen nichtflüchtigen Speicher (M) zum Speichern von Daten, die vom Prozessor (P) geliefert werden, wobei das Verfahren folgende Schritte umfasst:
Detektieren eines Ausschaltzustands der Stromversorgung (P2) durch wiederholtes Prüfen des Ausschaltsignals (PDD); auf die Detektion hin, dass das Ausschaltsignal (PDD) einen Wert (S0) aufweist, der dem Ausschaltzustand entspricht, Abschließen eines laufenden Schreibvorgangs und Stoppen der Speicherung von Daten, **dadurch gekennzeichnet, dass** das Produkt ferner eine Entladeschaltung (D) umfasst, die durch das Ausschaltsignal (PDD) gesteuert ist, zum Entladen der anderen Versorgung im Wesentlichen nur dann, wenn die Entladeschaltung (D) leitend ist, die nur dann leitend ist, wenn das Ausschaltsignal (PDD) den Wert (SO) aufweist, der dem Ausschaltzustand entspricht, und dass das Verfahren ferner den Schritt des Entladens der anderen Versorgung mit der Entladeschaltung (D) umfasst, wenn das Ausschaltsignal (PDD) den Wert (S0) aufweist, der dem Ausschaltzustand entspricht.

## Revendications

1. Produit comportant :
une alimentation électrique (P2) ;
un processeur (P) ayant une entrée pour recevoir un signal de mise hors tension (PDD) indiquant un état de l'alimentation électrique (P2) et ayant une autre entrée (Q) couplée à une autre alimentation ;
une mémoire non volatile (M) pour le stockage de données fournies par le processeur (P),
le processeur étant adapté pour :
détecter un état de mise hors tension de l'alimentation électrique (P2) en vérifiant de façon répétée le signal de mise hors tension (PDD) ; et
après avoir détecté que le signal de mise hors tension (PDD) présente une valeur (SO) correspondant à l'état de mise hors tension, terminer une opération d'écriture en cours, et arrêter le stockage des données, **caractérisé par** un circuit de décharge (D) contrôlé par ledit signal de mise hors tension (PDD) pour décharger l'autre alimentation, essentiellement seulement lorsque l'unité formant circuit de décharge (D) est conductrice, le circuit de décharge (D) n'étant conducteur que lorsque le signal de mise hors tension (PDD) présente la valeur (S0) correspondant à l'état de mise hors tension.

2. Produit selon la revendication 1, dans lequel le circuit de décharge (D) comprend un commutateur (S) électronique.

3. Produit selon la revendication 1, dans lequel le circuit de décharge (D) est adapté pour transporter un courant de décharge prédéterminé lorsque le signal de mise hors tension présente la valeur (S0) correspondant à l'état de mise hors tension

4. Procédé pour empêcher un stockage incorrect de données dans un produit, lequel produit comprend :
une alimentation électrique (P2) ;
un processeur (P) ayant une entrée destinée à recevoir un signal de mise hors tension (PDD) indiquant un état de l'alimentation électrique (P2) et ayant une autre entrée (Q) couplée à une autre alimentation ; et
une mémoire non-volatile (M) destinée au stockage de données fournies par le processeur (P), le procédé comprenant les étapes de :
détection d'un état de de mise hors tension de l'alimentation électrique (P2) en vérifiant de façon répétée le signal de mise hors tension (PDD) ;
après avoir détecté que le signal de mise hors tension (PDD) présente une valeur (S0) correspondant à l'état de mise hors tension, terminer une opération d'écriture en cours, et arrêter le stockage des données; **caractérisé en ce que** le produit comporte en outre un circuit de décharge (D) contrôlé par le signal de mise hors tension (PDD) pour décharger l'autre alimentation, essentiellement seulement lorsque le circuit de décharge (D) est conducteur, lequel circuit de décharge (D) n'étant conducteur que lorsque le signal de mise hors tension (PDD) présente une valeur (S0) correspondant à l'état de mise hors tension, et **en ce que** le procédé comprend, en outre, l'étape de décharge de l'autre alimentation avec le circuit de décharge (D) lorsque le signal de mise hors tension (PDD) présente une valeur (S0) correspondant à l'état de mise hors tension.
